(19) Europäisches Patentamt
European Patent Office
Office européen des brevets

(11) **EP 2 261 117 B1**

(12) **EUROPÄISCHE PATENTSCHRIFT**

(45) Veröffentlichungstag und Bekanntmachung des Hinweises auf die Patenterteilung:
**12.12.2018 Patentblatt 2018/50**

(51) Int Cl.:
***B64C 21/10*** *(2006.01)* ***F15D 1/00*** *(2006.01)*

(21) Anmeldenummer: **10165775.7**

(22) Anmeldetag: **12.06.2010**

(54) **Verfahren zur Herstellung einer mikrostrukturierten Folie**

Method for producing a microstructured film

Procédé de fabrication d'une feuille micro-structurée

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(30) Priorität: **12.06.2009 AT 9052009**

(43) Veröffentlichungstag der Anmeldung:
**15.12.2010 Patentblatt 2010/50**

(73) Patentinhaber: **Leitl, Peter Adrian**
**8010 Graz (AT)**

(72) Erfinder: **Leitl, Peter Adrian**
**8010 Graz (AT)**

(74) Vertreter: **Wirnsberger, Gernot**
**Wirnsberger & Lerchbaum Patentanwälte OG**
**Mühlgasse 3**
**8700 Leoben (AT)**

(56) Entgegenhaltungen:
**EP-A1- 0 127 192       EP-A1- 0 205 289**
**WO-A1-2007/036349   WO-A2-2004/021451**
**DE-A1- 3 609 541       DE-A1- 10 144 259**
**DE-C1- 19 650 439     US-A- 5 114 099**

## Beschreibung

Die Erfindung betrifft ein Verfahren zur Herstellung einer Mikrostrukturen in Form von Längsrippen aufweisenden Folie, die auf einem in einem Medium zu bewegenden oder in diesem bewegten Körper aufgebracht wird, sodass die Längsrippen außenseitig liegen, um mit dem Medium in Kontakt zu stehen und einen Strömungswiderstand des Körpers im Medium zu reduzieren.

Des Weiteren betrifft die Erfindung eine Verwendung einer Folie.

Wenn sich ein Körper in einem Medium wie einem Gas oder einer Flüssigkeit bewegt oder darin bewegt wird, ist in der Regel eine Strömung mit einer turbulenten Grenzschicht zu einer Oberfläche des Körpers hin gegeben. Diese turbulente Grenzschicht weist in unmittelbarer Nähe der Oberfläche des Körpers eine sogenannte laminare Unterschicht auf, die hochviskos ist. Über der laminaren Unterschicht der turbulenten Grenzschicht bilden sich Wirbelballen aus, die zu Querströmungen führen, was im Vergleich mit einer ausschließlich laminaren Grenzschicht eine erhöhte Reibung bzw. einen erhöhten Reibungsverlust bewirkt.

Es ist bekannt, dass ein auf eine turbulente Grenzschicht zurückzuführender Reibungsverlust eines in einem Medium bewegten Körpers, beispielsweise eines in der Atmosphäre bewegten Flugzeuges, verringert werden kann, wenn die Oberfläche des Körpers mit Längsrippen ausgebildet ist, die in Strömungsrichtung verlaufen und Dimensionen und Abstände im Mikrometerbereich aufweisen. Die Längsrippen, in der Fachsprache auch Riblets genannt, können eine Reibung verringern, obwohl an sich im Vergleich mit einer ebenen Fläche eine höhere Reibung und damit höhere Reibungsverluste zu erwarten sind, da die Längsrippen vergleichsweise zu einer größeren Oberfläche führen. Theoretisch scheint noch keine vollständige und überzeugende Erklärung dieses Effektes gegeben zu sein. Eine theoretische Erklärung geht dahin, dass die Längsrippen bei Ausbildung in einer bestimmten Höhe über die laminare Unterschicht hinaus Querströmungen bzw. einen Impulsaustausch zwischen Wirbelballen in Querrichtung vermindern, was eine geringere Reibung bewirken soll.

In Versuchen konnte im Strömungskanal an ebenen Platten bei Aufbringung von geeigneten Längsrippen eine Reibungsverminderung von bis zu 10 % festgestellt werden. Aufgrund dieses doch beträchtlichen Effektes wurde bereits versucht, dieses Konzept zwecks Kraftstoffersparnis auf Flugzeuge zu übertragen, aber auch bei anderen Gegenständen wie Rotorblättern von Windkraftanlagen zu nutzen.

Um das Konzept der Reibungsverminderung durch Strukturierung einer Oberfläche ohne größere Limitierungen in der Praxis anwenden zu können, werden Folien hergestellt, die an einer Oberfläche Längsrippen aufweisen. Die Folien können dann auf bestehenden Objekten, beispielsweise Flugzeugen, befestigt werden. In der Praxis stellt sich allerdings das Problem, dass ein mit einer Folie im Oberflächenbereich zu modifizierender Körper, beispielsweise ein Flugzeugflügel, in der Regel eine komplexe Struktur mit lokal stark unterschiedlichen Gegebenheiten aufweist. Aufgebrachte Folien sind daher oftmals wenig effizient in Bezug auf eine Verminderung von Reibung bei Bewegung des Körpers, sodass die in Versuchen erreichten theoretischen Werte einer Reibungsverminderung von bis zu 10 % zumindest häufig auch nicht nur annähernd erreicht werden. Dies ist insbesondere darauf zurückzuführen, dass aufgrund einer komplexen Struktur eines Körpers in verschiedenen Oberflächenbereichen verschiedene Längsrippenabstände optimal wären. Entsprechende Folien lassen sich allerdings nicht in wirtschaftlicher Weise herstellen.

Dokument EP 0 205 289 A1 zeigt ein Verfahren zur Herstellung einer Mikrostrukturen in Form von Längsrippen aufweisende Folie. Es wird als nächstliegender Stand der Technik angesehen und offenbart den Oberbegriff des Anspruchs 1.

Dokument DE 196 50 439 C1 offenbart eine Oberfläche mit Längsrippen, wobei zur Berechnung des seitlichen Rippenabstands eine Wandschubspannung einer glatten Referenzoberfläche herangezogen wird.

Hier setzt die Erfindung an. Aufgabe der Erfindung ist es, ein Verfahren der eingangs genannten Art anzugeben, das eine effiziente Herstellung einer Folie für einen großflächigen Körper komplexer Struktur erlaubt, wobei lokalen Gegebenheiten des Körpers Rechnung getragen wird.

Diese Aufgabe wird bei einem Verfahren der eingangs genannten Art gelöst, wenn ein Abstand der Längsrippen in Bezug auf eine Reduzierung des Strömungswiderstandes des Körpers im Medium berechnet wird, wonach zumindest eine metallische Komponente erstellt wird, die Negativkonturen der Längsrippen im berechneten Abstand aufweist, wonach ein Folienrohling bereitgestellt wird, worauf mit der zumindest einen Komponente die Längsrippen am bzw. im Folienrohling unter Bildung der Längsrippen aufweisenden Folie eingeformt werden.

Die mit einem erfindungsgemäßen Verfahren erzielten Vorteile sind insbesondere darin zu sehen, dass eine effiziente Herstellung einer günstig ausgelegten Folie für einen großflächigen Körper komplexer Struktur möglich ist, wobei lokalen Gegebenheiten bzw. einer Struktur des Körpers im Hinblick auf eine signifikante Reibungsverminderung bei Bewegung des Körpers in einem Medium Rechnung getragen wird. Bei einem erfindungsgemäßen Verfahren wird eine Struktur bzw. geometrische Ausformung des Körpers, die letztlich auch einen Strömungswiderstand bei Bewegung des Körpers in einem Medium bestimmt, bei der Auslegung der Längsrippen berücksichtigt, sodass deren konstanter Abstand in Bezug auf eine große Reduzierung des Strömungswiderstandes des Körpers im Medium günstig ausgelegt ist. Da zumindest eine metallische Komponente erstellt wird, die Negativkonturen der Längsrippen im berechneten Abstand aufweist, ist einerseits ein einfaches und verschleißfestes Werkzeug zur Herstellung einer Folie für einen großflächigen Körper gegeben. Andererseits kann das erfindungsgemäße Verfahren flexibel angewendet werden, sodass mit relativ geringem Aufwand für einen Körper anderer Struktur ein günstiger Abstand der Längsrippen berechnet und auf Basis dieser Berechnung zumindest eine neue Komponente für die Herstellung einer oder mehrerer Folien erstellt werden kann.

Um bei einem Körper mit komplexer Struktur bzw. Geometrie möglichst in allen Bereichen mit dem vorgesehenen konstanten Abstand der Längsrippen eine effiziente Reibungsverminderung zu erreichen, ist erfindungsgemäß vorgesehen, dass der Abstand der Längsrippen berechnet wird, indem für eine vorgegebene Strömungsgeschwindigkeit und eine vorgegebene kinematische Viskosität punktuell oder kontinuierlich Wandschubspannungen am Körper und daraus eine mittlere Wandschubspannung bei einer Bewegung des Körpers im Medium berechnet wird, wonach für die ermittelte mittlere Wandschubspannung mithilfe der Beziehung

$$s+ \; = \; \frac{s\sqrt{\tau_W / \rho}}{\nu}$$

ein Wert s berechnet wird, der einem Abstand der Längsrippen entspricht, wobei ein Wert s+ im Bereich von 10 bis 20, vorzugsweise 12 bis 18, gewählt wird und wobei $\tau_W$ der mittleren Wandschubspannung, $\rho$ der Dichte des Mediums und $\nu$ der kinematischen Viskosität des Mediums entspricht. Der Abstand der Längsrippen ist dann in Bezug auf eine mittlere Wandschubspannung optimiert, wobei der Körper dreidimensional erfasst wird, was in der Regel zu guten Ergebnissen in Bezug auf eine Reibungsverminderung bei Bewegung des Körpers in einem Medium führt. Der Wertebereich von s+ von 10 bis 20 ergibt sich dabei aus experimentellen Beobachtungen, wonach für Objekte mit verschiedener Struktur, beispielsweise ebene Platten oder Flügelprofile, in diesem Wertebereich eine zufriedenstellende Reibungsverminderung erhalten wird. Zugleich ist eine einfache Herstellung der Folie bzw. gegebenenfalls mehrerer Folien gegeben, da wiederum lediglich zumindest eine metallische Komponente zu erstellen ist.

Damit sichergestellt werden kann, dass die Berechnung mithilfe der mittleren Wandschubspannung nicht in einem oder mehreren Oberflächenbereichen des Körpers zu unerwünscht niedriger Reibungsverminderung bei Bewegung des Körpers in einem Medium führt, kann vorgesehen sein, dass anhand der punktuell oder kontinuierlich ermittelten Wandschubspannungen für den ermittelten Wert s des Abstandes der Längsrippen überprüft wird, ob der Wert s+ für zumindest 70 %, vorzugsweise zumindest 80 %, insbesondere zumindest 95 %, der Werte der Wandschubspannungen zwischen 4 und 30, vorzugsweise zwischen 7 und 25, liegt, und bei Nichterfüllen dieses Kriteriums ein neuer Wert s+ und damit ein Abstand zwischen den Längsrippen gewählt wird, bis die Überprüfung positiv abgeschlossen wird.

Im Hinblick auf eine effiziente Verfahrensführung ist bevorzugt vorgesehen, dass nach Berechnung des Abstandes der Längsrippen durch Interferenzlithografie Abbilder der Längsrippen auf bzw. in einem Kunststoff erstellt werden, worauf die Abbilder der Längsrippen durch ein Metall oder eine Legierung negativ abgeformt und dadurch zumindest eine metallische Komponente mit entsprechenden Negativkonturen gebildet wird, worauf die Komponente auf einer Basis angeordnet wird, wonach der Folienrohling umfassend eine Trägerschicht und eine auf dieser Trägerschicht mittelbar oder unmittelbar angebrachte Deckschicht aus einem aushärtbaren Lack bereitgestellt wird, worauf mit der Basis mit der metallischen Komponente in dem aushärtbaren Lack des Folienrohlings die Längsrippen eingeformt werden, wonach der Lack ausgehärtet wird. Durch die Anwendung von Interferenzlithografie zur Erstellung der zumindest einen metallischen Komponente ergeben sich mehrere Vorteile. Zum einen ist es auf einfache Weise möglich, Daten aus der Berechnung des Abstandes der Längsrippen zur computerunterstützten Herstellung geeigneter Masken für eine Belichtung eines Kunststoffes zu verwenden. Zum anderen lassen sich durch Interferenzlithografie besonders exakte Abbilder der Längsrippen im berechneten Abstand erstellen, die durch das Metall oder die Legierung exakt negativ abgeformt werden können, sodass letztlich auch im Lack entsprechend präzise Mikrostrukturen bzw. Längsrippen erstellt werden können. Darüber hinaus bietet sich der Vorteil, dass mit der zumindest einen metallischen Komponente im Lack besonders einfach Längsrippen durch Anpressen derselben erstellt werden können. Im Zusammenhang damit ist bevorzugt vorgesehen, dass der Lack durch Bestrahlung mit ultraviolettem Licht ausgehärtet wird.

Sofern ein Folienrohling mit einer Deckschicht aus einem aushärtbaren Lack eingesetzt wird, empfiehlt es sich, dass der Folienrohling mit einer maximal 50 µm dicken Deckschicht bereitgestellt wird.

Die zumindest eine metallische Komponente wird vorzugsweise durch elektrochemische Abscheidung erstellt. Grundsätzlich ist es ausreichend, dass eine metallische Komponente erstellt wird, mit welcher die Längsrippen am bzw. im Folienrohling unter Bildung der Längsrippen aufweisenden Folie eingeformt werden. Bevorzugt ist jedoch vorgesehen, zumal die Herstellung metallischer Komponenten auf einfache Weise erfolgen kann, dass mehrere metallische Komponenten erstellt und auf einer Walze als Basis angeordnet werden. Ein Folienrohling kann dann bei der Herstellung der Folie unter einer Walze kontinuierlich hindurchgeführt werden, wobei die Walze rotiert, aber ortsfest angeordnet ist. Grundsätzlich ist es jedoch auch möglich, die zumindest eine metallische Komponente auf einem Stempel anzuordnen und mit dem Stempel Längsrippen an bzw. in einem Folienrohling einzuformen.

Der Folienrohling wird bevorzugt mit einer thermoplastischen Trägerschicht aus einem Polymer oder Copolymer bereitgestellt, die optional an einer Unterseite eine klebende Beschichtung umfasst. Die thermoplastische Trägerschicht sorgt für eine Stabilität der Folie und trägt gleichzeitig die vorzugsweise aus einem Lack bestehende Deckschicht mit den Längsrippen. Die klebende Beschichtung dient dazu, die Folie auf einer Oberfläche eines Körpers anbringen zu können.

Eine weitere Aufgabe der Erfindung besteht darin, eine Verwendung einer Folie, die an einer Oberfläche Mikrostrukturen in Form von Längsrippen aufweist, auf einer Oberfläche eines in einem Medium bewegten Körpers zur Reduzierung eines Strömungswiderstandes des Körpers zu ermöglichen, indem die Folie in Bezug auf eine Reibungsverminderung bei Bewegung des Körpers im Medium günstig ausgelegt ist.

Diese Aufgabe wird durch Verwendung einer Folie, die an einer Oberfläche Mikrostrukturen in Form von Längsrippen aufweist, auf einer Oberfläche eines in einem Medium bewegten Körpers zur Reduzierung eines Strömungswiderstandes des Körpers gelöst, wenn die Folie eine Trägerschicht aus einem thermoplastischen Material und eine darauf mittelbar oder unmittelbar aufgebrachte Deckschicht umfasst, wobei auf bzw. in der Deckschicht die Längsrippen eingeformt sind, die einen Abstand aufweisen, welcher einem Wert s in der Beziehung

$$s+ \;=\; \frac{s\sqrt{\tau_W/\rho}}{v}$$

entspricht, wobei ein Wert s+ im Bereich von 10 bis 20, vorzugsweise 12 bis 18, gewählt ist und wobei $\tau_W$ der mittleren Wandschubspannung, $\rho$ der Dichte des Mediums und v der kinematischen Viskosität des Mediums entspricht.

Ein durch eine erfindungsgemäße Verwendung erzielter Vorteil ist insbesondere darin zu sehen, dass eine Folie eingesetzt wird, die in weiten Bereichen einer Oberfläche des Körpers zu einer effizienten Reibungsverminderung bei Bewegung des Körpers im Medium führt, auch wenn näherungsweise bloß eine mittlere Wandschubspannung zur Berechnung eines Abstandes der Längsrippen berücksichtigt wird. Zwar wären grundsätzlich noch bessere Ergebnisse möglich, wenn eine oder mehrere Folien eingesetzt werden würden, die jeweils lokal eine maximierte Reibungsverminderung bewirken - dies würde allerdings einen Herstellungsaufwand vervielfachen, was nicht zweckmäßig wäre.

Die Deckschicht der Folie besteht vorzugsweise aus einem ausgehärteten Lack und kann eine maximale Dicke von 50 μm, vorzugsweise 15 μm, aufweisen. Weiter bedeckt die Deckschicht vorzugsweise eine optional zwischen Trägerschicht und Deckschicht angeordnete Haftvermittlungsschicht oder die Trägerschicht im Wesentlichen vollständig, sodass die letzteren Schichten durch die Deckschicht vor Umwelteinflüssen geschützt sind.

Die Trägerschicht weist mit Vorteil eine maximale Dicke von 5 bis 75 μm, vorzugsweise 10 bis 25 μm, auf, um der Folie eine ausreichende Stabilität zu verleihen, ohne dass ein durchschnittliches Flächengewicht der Folie unerwünscht groß ist.

Die Längsrippen können in Art eines Sägezahnprofils aneinander anliegen, aber auch voneinander durch ebene Flächen der Deckschicht getrennt sein.

Die Folie ist bevorzugt so leicht wie möglich ausgebildet und weist beispielsweise eine durchschnittliche Masse bzw. ein Flächengewicht von weniger als 300 gm$^{-2}$, vorzugsweise weniger als 50 gm$^{-2}$, auf.

Bevorzugt ist es, dass die Längsrippen neben dem eigentlichen Rillenprofil zusätzlich eine Substruktur aufweisen, die beispielsweise ein Anhaften von Staubpartikeln oder anderen Partikeln wie auch einer Flüssigkeit ähnlich dem Lotuseffekt verringert oder ausschließt.

Weitere Merkmale, Vorteile und Wirkungen der Erfindung ergeben sich aus der nachfolgenden Beschreibung eines Ausführungsbeispiels. In den Zeichnungen zeigen:

Fig. 1 eine auf einem Körper aufgebrachte Folie mit Längsrippen im Querschnitt normal zu den Längsrippen;
Fig. 2 eine Geschwindigkeitsverteilung rund um einen Körper für eine einzelne Ebene;
Fig. 3 eine Verteilung einer Wandschubspannung für den Körper gemäß Fig. 2;
Fig. 4 eine Verteilung eines dimensionslosen Wertes s+ in Abhängigkeit eines gewählten Abstandes von Längsrippen für den Körper gemäß Fig. 2.

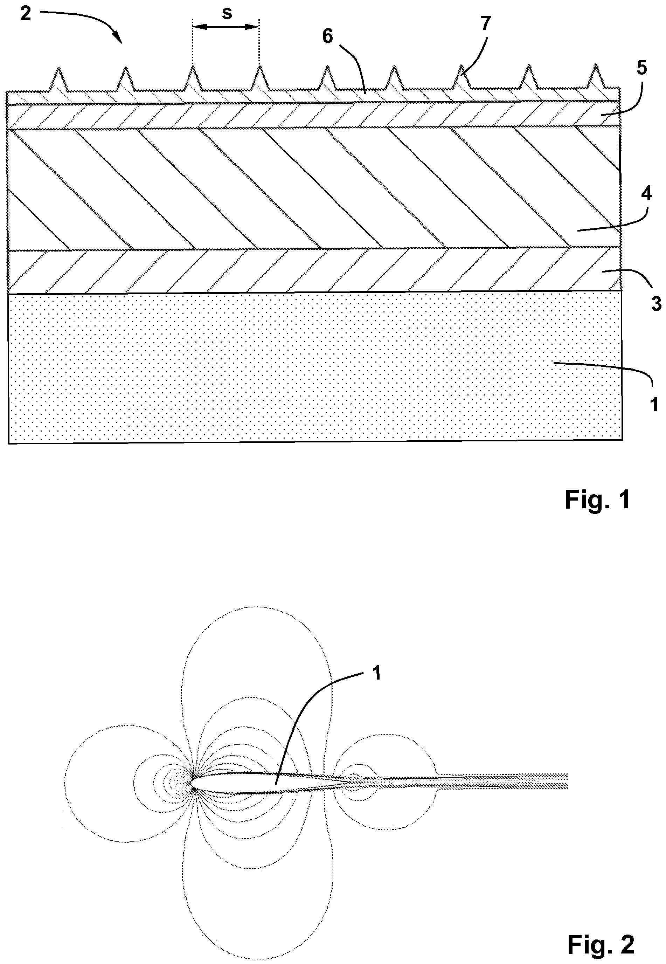

In Fig. 1 ist eine auf einem Körper 1 aufgebrachte Folie 2 mit Längsrippen 7 im Querschnitt normal zu den Längsrippen 7 dargestellt. Bei dem Körper 1 kann es sich um einen beliebigen Gegenstand handeln, der sich in einem Gas oder einer Flüssigkeit bewegt oder darin bewegt wird, beispielsweise ein Flugzeug, ein Boot oder Schiff, ein Surfbrett, ein Kraftfahrzeug oder ein Rotorblatt einer Windkraftanlage. Die Folie 2 umfasst vom Körper 1 ausgehend betrachtet zunächst eine klebende Beschichtung 3, durch welche die Folie 2 am Körper 1 dauerhaft gehalten wird, auch bei hohen Geschwindigkeiten, die z. B. bei Flugzeugen gegeben sein können. Die klebende Beschichtung 3 ist in Fig. 1 in Relation zu weiteren Schichten der Folie 2 vergrößert dargestellt. In der Praxis wird eine Dicke der klebenden Beschichtung 3 so gering wie möglich gehalten, da die klebende Beschichtung lediglich dem Zweck der Befestigung der Folie 2 am Körper 1 dient. An die klebende Beschichtung 3 schließt eine Trägerschicht 4 an, welche der Folie 2 Stabilität verleiht und in der Regel aus einem Polymer oder Copolymer wie Polyethylen, Polypropylen, Polystyrol, Polyvinylacetat, Polyvinylchlorid oder einem Ethylen-Vinylacetat-Copolymer besteht. Die Wahl des Polymers oder Copolymers ist an sich nicht kritisch. Das Polymer oder Copolymer soll jedoch eine lange Lebensdauer aufweisen und beständig bei Bedingungen wie intensiver Sonneneinstrahlung und/oder Temperaturwechseln sein, welchen Bedingungen die Folie 2 im Einsatz ausgesetzt sein kann. Die Trägerschicht 4 ist für eine Reibungsverminderung nicht erheblich und soll daher ähnlich der klebenden Beschichtung 3 mit möglichst geringer Dicke ausgeführt sein, jedoch der Folie 2 wie erwähnt die erforderliche Stabilität verleihen. Diesbezüglich erweist es sich als zweckmäßig, wenn die Trägerschicht 4 mit einer Dicke von 5 bis 75 $\mu$m, vorzugsweise 10 bis 25 $\mu$m, ausgebildet ist. Auf der Trägerschicht 4 kann eine Haftvermittlungsschicht 5 vorliegen, die eine Haftung einer abschließenden Deckschicht 6 verbessert. Die Deckschicht 6, die aus einem ausgehärteten Lack besteht, bedeckt die Haftvermittlungsschicht 5 vollständig. In der Deckschicht 6 sind Längsrippen 7 eingeformt, die mit einem Medium, in dem sich der Körper 1 bewegt oder in welchem dieser bewegt wird, in Kontakt stehen und aufgrund eines geeigneten Abstandes der Spitzen der Längsrippen 7 einen Reibungsverlust des Körpers 1 bei Bewegung in einem Medium reduzieren. Die Deckschicht 6 weist ebenfalls eine möglichst geringe Dicke auf, damit eine durchschnittliche Masse bzw. ein Flächengewicht der Folie 2 möglichst niedrig bleibt und z. B. eine durch die Folie 2 potenzielle Kraftstoffersparnis nicht durch ein großes zusätzliches Gewicht der Folie 2 kompensiert wird. Vorteilhafterweise beträgt eine Dicke der Deckschicht 6 weniger als 50 $\mu$m, vorzugsweise weniger als 15 $\mu$m. Die Längsrippen 7 können wie dargestellt ein etwa dreieckiges Querschnittsprofil aufweisen und voneinander beabstandet sein. Die Längsrippen 7 können jedoch auch aneinander anliegen und im Querschnitt ein Sägezahnprofil bilden. Auch andere Querschnittsprofile sind möglich.

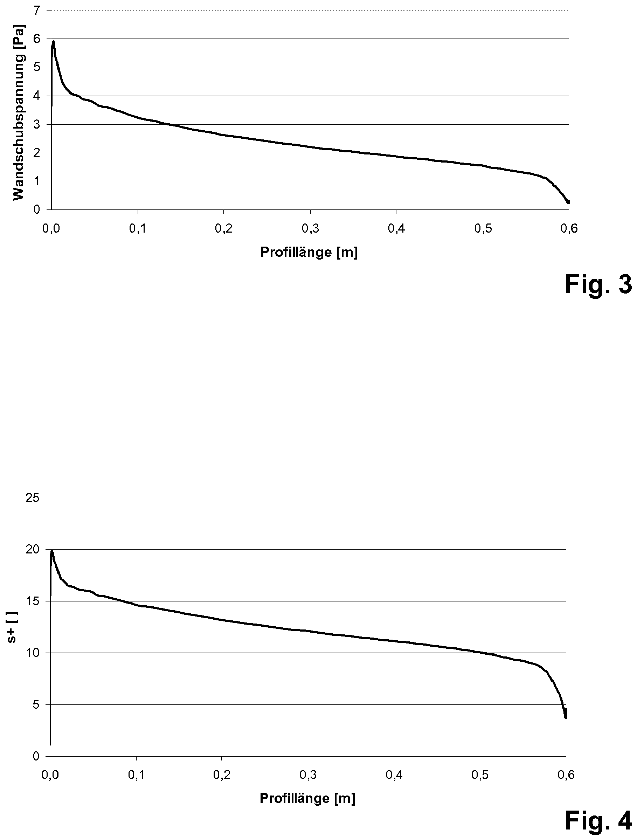

Eine in Bezug auf einen Reibungsverlust eines Körpers 1 günstig ausgelegte Folie 2 wird wie folgt hergestellt: In einem ersten Schritt wird für den Körper 1 eine Verteilung der Wandschubspannung berechnet, wobei eine dreidimensionale Struktur des Körpers 1 vollständig berücksichtigt wird. Um eine Verteilung der Wandschubspannung bzw. Wandschubspannungen um den Körper 1 herum zu erhalten, ist es vorerst zweckmäßig, mittels computerunterstützter Analyse Strömungszustände und insbesondere eine Geschwindigkeitsverteilung bzw. Strömungsgeschwindigkeit um den Körper 1 herum zu analysieren. Dabei werden Rahmenbedingungen für die computerunterstützte Analyse vorgegeben, indem berücksichtigt wird, in welchem Medium bzw. in welchem Geschwindigkeitsbereich sich der mit der Folie 2 zu adaptierende Körper 1 im Einsatz bewegt bzw. bewegt wird und geeignete Mittelwerte angenommen. Anhand der Analyse der Strömungsgeschwindigkeit bzw. der Verteilung der Strömungsgeschwindigkeit, die in Fig. 2 exemplarisch für ein Flügelprofil eines Flugzeuges dargestellt ist, und unter Annahme einer kinematischen Viskosität für das Medium im Einsatzbereich kann eine Verteilung der Wandschubspannung um den Körper 1 herum berechnet werden. Das Ergebnis einer derartigen Berechnung ist in Fig. 3 dargestellt. In einem zweiten Schritt wird anhand der berechneten Verteilung der Wandschubspannung eine mittlere Wandschubspannung berechnet, auf deren Basis mithilfe der Beziehung

$$s+ \ = \ \frac{s\sqrt{\tau_W / \rho}}{\nu}$$

ein Wert s berechnet wird, der einem Abstand der Längsrippen 7 in Fig. 1 entspricht, wobei ein Wert s+ im Bereich von 10 bis 20, vorzugsweise 12 bis 18, gewählt wird und wobei $\tau_W$ der mittleren Wandschubspannung, $\rho$ der Dichte des Mediums und $\nu$ der kinematischen Viskosität des Mediums entspricht. Die Wahl des Wertes s+ im genannten Bereich ergibt sich aus Erfahrungswerten, wonach bei entsprechender Wahl für verschiedene Profile grundsätzlich Abstände der Längsrippen 7 erhalten werden, die zu akzeptablen Ergebnissen führen. Beispielsweise ist aus experimentellen Untersuchungen bekannt, dass Längsrippen 7 an ebenen Platten eine optimale Wirkung erzielen, wenn s+ gleich 17 ist. Für Flügelprofile hingegen hat sich gezeigt, dass s+ mit Vorteil im Bereich von 12,5 gewählt wird. Ist der Abstand der Längsrippen 7 festgelegt, so wird in einem weiteren Schritt überprüft, ob bei dem ermittelten Abstand der Längsrippen 7 einzelne Werte s+ zwischen 3 und 40, vorzugsweise zwischen 7 und 25, liegen, wenn nicht die berechnete mittlere Wandschubspannung, sondern die punktuell oder kontinuierlich ermittelten Wandschubspannungen berücksichtigt werden. Von Vorteil ist es, wenn möglichst viele, insbesondere zumindest 95 %, der Werte der Wandschubspannungen im genannten Bereich liegen, wie z. B. in Fig. 4. Sofern diese Überprüfung positiv abgeschlossen wird, sind die Längsrippen 7 für einen Strömungszustand des Körpers 1 bei einer bestimmten mittleren Strömungsgeschwindigkeit, einer bestimmten mittleren kinematischen Viskosität und unter Berücksichtigung der Struktur des Körpers 1 ausgelegt. Um eine Struktur der Längsrippen 7 zu definieren, ist es schließlich noch notwendig, deren Höhe sowie das Querschnittsprofil festzulegen. Die Höhe der Längsrippen 7 wird zweckmäßigerweise in Bezug auf den ermittelten Abstand der Längsrippen 7 festgelegt. Mit Vorteil beträgt eine Höhe der Längsrippen 7 das 0,1- bis 1,5-fache, vorzugsweise 0,3- bis 0,6-fache, des Abstandes der Längsrippen 7. Durch Variation eines Verhältnisses der Höhe der Längsrippen 7 zu deren Abstand kann noch eine Feinabstimmung des Längsrippenprofils an einen vorgegebenen Geschwindigkeitsbereich, in dem sich der Körper 1 bewegen soll, erfolgen. Ähnlich kann durch eine Änderung des Querschnittsprofils der Längsrippen 7, vor allem Kopf- und/oder Fußradius sowie Flankenwinkel, eine Feinanpassung des Längsrippenprofils durchgeführt werden. Nach Durchführung dieser Schritte ist eine Folie 2 mit mikrostrukturierter Oberfläche für einen Einsatz auf einem Körper 1 günstig ausgelegt.

Nach Berechnung der Struktur der Folie 2 wird ein Werkzeug zur Herstellung einer Folie 2 erstellt, wobei auf die Daten der Berechnung zurückgegriffen wird. Dabei wird so vorgegangen, dass ein fotoempfindliches Material, z. B. ein Kunststoff, mit einem großflächig aufgeweiteten Strahl eines ultravioletten Lasers durch eine Maske hindurch beaufschlagt wird. Die Maske ist dabei so ausgelegt, dass im Kunststoff Abbilder der Längsrippen 7 wie berechnet bzw. ausgelegt erhalten werden. Nach Entfernung der nicht belichteten Stellen des Kunststoffes liegen Abbilder der Längsrippen 7 im Kunststoff vor, die mittels eines Metalls oder einer Legierung abgeformt werden. Hierfür eignet sich insbesondere ein Verfahren, dass unter dem Begriff Elektroplating bekannt ist und auf elektrochemischer Abscheidung eines Metalls wie Nickel aus einer Lösung basiert. Mit dieser Abformmethode können ein oder mehrere metallische Komponenten aus Nickel oder Chrom hergestellt werden, die in der Regel eine Dicke von 50 μm bis 3 mm haben und Negativkonturen der Längsrippen 7 aufweisen. Diese Komponenten werden anschließend auf einer Walze angeordnet, mit deren Hilfe die Längsrippen 7 am bzw. in einem Folienrohling eingeformt werden. Dabei wird so vorgegangen, dass ein Folienrohling bereitgestellt wird, der von der klebenden Beschichtung 3 bis hin zur Haftvermittlungsschicht 5 analog wie die in Fig. 1 dargestellte Folie 2 aufgebaut ist, jedoch außenseitig eine ebene Schicht aus einem aushärtbaren Lack aufweist. In diesem aushärtbaren Lack werden die Längsrippen 7 eingeformt, indem der Folienrohling unter der Walze mit den Komponenten mit den Negativkonturen der Längsrippen 7 hindurchgeführt wird, wobei die Walze unter Rotation auf den Folienrohling drückt. Im Anschluss an die Walze ist zumindest eine Strahlungsquelle angeordnet, mit welcher der noch nicht ausgehärtete Lack mit ultraviolettem Licht beaufschlagt werden kann, sodass letztlich die Deckschicht 6 mit den Längsrippen 7 in einen festen, einsatztauglichen Zustand überführt wird.

Die metallischen Komponenten können alternativ auch auf einem oder mehreren Stempeln angeordnet werden, mit welchen Folienrohlinge geprägt werden, um Längsrippen 7 mit Abmessungen und Abständen voneinander im Mikrometerbereich einzuformen. Dabei bleiben zwischen den Prägestrukturen einzelner Stempel bzw. aufeinanderfolgender Prägeschritte entlang einer Bahn eines Folienrohlings kleine Bereiche ohne Längsrippen 7 erhalten, was grundsätzlich nicht störend ist, wenngleich für Anwendungen mit höchster Folienqualität eine Einformung von Längsrippen 7 mit einer Walze bevorzugt ist.

## Patentansprüche

1. Verfahren zur Herstellung einer Mikrostrukturen in Form von Längsrippen (7) aufweisenden Folie (2), die auf einem in einem Medium zu bewegenden oder in diesem bewegten Körper (1) aufgebracht wird, sodass die Längsrippen (7) außenseitig liegen, um mit dem Medium in Kontakt zu stehen und einen Strömungswiderstand des Körpers (1) im Medium zu reduzieren, **dadurch gekennzeichnet, dass** ein Abstand der Längsrippen (7) in Bezug auf eine Reduzierung des Strömungswiderstandes des Körpers (1) im Medium berechnet wird, indem für eine vorgegebene Strömungsgeschwindigkeit und eine vorgegebene kinematische Viskosität punktuell oder kontinuierlich Wandschubspannungen am Körper (1) und daraus eine mittlere Wandschubspannung bei einer Bewegung des Körpers (1) im Medium berechnet wird, wonach für die ermittelte mittlere Wandschubspannung mithilfe der Beziehung

$$s_+ = \frac{s\sqrt{\tau_W / \rho}}{v}$$

ein Wert s berechnet wird, der einem Abstand der Längsrippen (7) entspricht, wobei ein Wert s+ im Bereich von 10 bis 20, vorzugsweise 12 bis 18, gewählt wird und wobei $\tau_W$ der mittleren Wandschubspannung, $\rho$ der Dichte des Mediums und v der kinematischen Viskosität des Mediums entspricht, wonach zumindest eine metallische Komponente erstellt wird, die Negativkonturen der Längsrippen (7) im berechneten Abstand aufweist, wonach ein Folienrohling bereitgestellt wird, worauf mit der zumindest einen Komponente die Längsrippen (7) am bzw. im Folienrohling unter Bildung der Längsrippen (7) aufweisenden Folie (2) eingeformt werden.

2. Verfahren nach Anspruch 1, **dadurch gekennzeichnet, dass** anhand der punktuell oder kontinuierlich ermittelten Wandschubspannungen für den ermittelten Wert s des Abstandes der Längsrippen (7) überprüft wird, ob der Wert s+ für zumindest 70 %, vorzugsweise zumindest 80 %, insbesondere zumindest 95 %, der Werte der Wandschubspannungen zwischen 4 und 30, vorzugsweise zwischen 7 und 25, liegt, und bei Nichterfüllen dieses Kriteriums ein neuer Wert s+ und damit ein Abstand zwischen den Längsrippen (7) gewählt wird, bis die Überprüfung positiv abgeschlossen wird.

3. Verfahren nach Anspruch 1 oder 2, **dadurch gekennzeichnet, dass** nach Berechnung des Abstandes der Längsrippen (7) durch Interferenzlithografie Abbilder der Längsrippen (7) auf bzw. in einem Kunststoff erstellt werden, worauf die Abbilder der Längsrippen (7) durch ein Metall oder eine Legierung negativ abgeformt und dadurch zumindest eine metallische Komponente mit entsprechenden Negativkonturen gebildet wird, worauf die Komponente auf einer Basis angeordnet wird, wonach der Folienrohling umfassend eine Trägerschicht (4) und eine auf dieser Trägerschicht (4) mittelbar oder unmittelbar angebrachte Deckschicht (6) aus einem aushärtbaren Lack bereitgestellt wird, worauf mit der Basis mit der metallischen Komponente in dem aushärtbaren Lack des Folienrohlings die Längsrippen (7) eingeformt werden, wonach der Lack ausgehärtet wird.

4. Verfahren nach Anspruch 3, **dadurch gekennzeichnet, dass** der Lack durch Bestrahlung mit ultraviolettem Licht ausgehärtet wird.

5. Verfahren nach Anspruch 3 oder 4, **dadurch gekennzeichnet, dass** der Folienrohling mit einer maximal 50 μm dicken Deckschicht (6) aus dem aushärtbaren Lack bereitgestellt wird.

6. Verfahren nach einem der Ansprüche 3 bis 5, **dadurch gekennzeichnet, dass** die zumindest eine metallische Komponente durch elektrochemische Abscheidung erstellt wird.

7. Verfahren nach einem der Ansprüche 1 bis 6, **dadurch gekennzeichnet, dass** mehrere metallische Komponenten erstellt und auf einer Walze als Basis angeordnet werden.

8. Verfahren nach einem der Ansprüche 1 bis 7, **dadurch gekennzeichnet, dass** der Folienrohling mit einer thermoplastischen Trägerschicht (4) aus einem Polymer oder Copolymer bereitgestellt wird, die optional an einer Unterseite eine klebende Beschichtung (3) umfasst.

9. Verwendung einer Folie (2), die an einer Oberfläche Mikrostrukturen in Form von Längsrippen (7) aufweist, auf einer Oberfläche eines in einem Medium bewegten Körpers (1) zur Reduzierung eines Strömungswiderstandes des Körpers (1), wobei die Folie (2) eine Trägerschicht (4) aus einem thermoplastischen Material und eine darauf mittelbar oder unmittelbar aufgebrachte Deckschicht (6) umfasst, wobei auf bzw. in der Deckschicht (6) die Längsrippen (7) eingeformt sind, die einen Abstand aufweisen, welcher einem Wert s in der Beziehung

$$ s+ \ = \ \frac{s\sqrt{\tau_W / \rho}}{\nu} $$

entspricht, wobei ein Wert s+ im Bereich von 10 bis 20, vorzugsweise 12 bis 18, gewählt ist und wobei $\tau_W$ der mittleren Wandschubspannung, ρ der Dichte des Mediums und ν der kinematischen Viskosität des Mediums entspricht.

10. Verwendung einer Folie (2) nach Anspruch 9, wobei die Deckschicht (6) aus einem ausgehärteten Lack besteht.

11. Verwendung einer Folie (2) nach Anspruch 10, wobei die Deckschicht eine maximale Dicke von 50 μm, vorzugsweise 15 μm, aufweist.

12. Verwendung einer Folie (2) nach einem der Ansprüche 9 bis 11, wobei die Deckschicht (6) eine optional zwischen Trägerschicht (4) und Deckschicht (6) angeordnete Haftvermittlungsschicht (5) oder die Trägerschicht (4) im Wesentlichen vollständig bedeckt.

13. Verwendung einer Folie (2) nach einem der Ansprüche 9 bis 12, wobei die Trägerschicht (4) eine maximale Dicke von 5 bis 75 μm, vorzugsweise 10 bis 25 μm, aufweist.

14. Verwendung einer Folie (2) nach einem der Ansprüche 9 bis 13, wobei die Längsrippen (7) voneinander durch ebene Flächen der Deckschicht (6) getrennt sind.

15. Verwendung einer Folie (2) nach einem der Ansprüche 9 bis 14, wobei die Folie (2) eine durchschnittliche Masse von weniger als 300 gm$^{-2}$, vorzugsweise weniger als 50 gm$^{-2}$, aufweist.

16. Verwendung einer Folie (2) nach einem der Ansprüche 9 bis 15, wobei die Längsrippen (7) eine Substruktur aufweisen.

**Claims**

1. A method of producing a film (2) exhibiting microstructures in the form of longitudinal ribs (7) which is applied to a body (1) to move or be moved in a medium, so that the longitudinal ribs (7) lie on the outside, in order to be in contact with the medium and to reduce a flow resistance of the body (1) in the medium, **characterized in that** a spacing of the longitudinal ribs (7) is calculated in order to reduce the flow resistance of the body (1) in the medium, **in that** for a predefined flow velocity and a predefined kinematic viscosity wall shear stresses are calculated at certain points or continuously on the body (1) and, from these, a mean wall shear stress during a movement of the body (1) in the medium is calculated, according to which for the mean wall shear stress determined with the help of the equation

$$ s+ \ = \ \frac{s\sqrt{\tau_W / \rho}}{\nu} $$

a value s is calculated which corresponds to a spacing of the longitudinal ribs (7), wherein a value s+ in the range of 10 to 20, preferably 12 to 18, is selected and wherein $\tau_W$ corresponds to the mean wall shear stress, ρ to the density of the medium and ν to the

kinematic viscosity of the medium, according to which at least one metallic component is produced which has negative contours of the longitudinal ribs (7) with the calculated spacing according to which a film blank is supplied, whereupon with the at least one component the longitudinal ribs (7) are formed on or in the film blank while the film (2) exhibiting longitudinal ribs (7) is formed.

2. The method according to claim 1, **characterized in that** with the help of the wall shear stresses determined at certain points or continuously for the determined value s of the spacing of the longitudinal ribs (7), a check is made as to whether the value s+ lies between 4 and 30, preferably between 7 and 25, for at least 70 %, preferably at least 80 %, in particular at least 95 %, of the values of the wall shear stresses, and if this criterion is not fulfilled, a new value s+ and therefore a spacing between the longitudinal ribs (7) is chosen until the outcome of the check is positive.

3. The method according to claim 1 or 2, **characterized in that** after calculating the spacing of the longitudinal ribs (7) images of the longitudinal ribs (7) are created on or in a plastic using interference lithography, after which the images of the longitudinal ribs (7) are negatively formed by a metal or an alloy and at least one metallic component with corresponding negative contours is thereby created, following which the component is arranged on a base after which the film blank comprising a carrier layer (4) and a top layer (6) of a curable lacquer is applied directly or indirectly to this carrier layer (4), after which the longitudinal ribs (7) are formed with the base with the metallic component in the curable lacquer of the film blank.

4. The method according to claim 3, **characterized in that** the lacquer is cured by radiation using ultraviolet light.

5. The method according to claim 3 or 4, **characterized in that** the film blank is supplied with a top layer (6) of the curable lacquer with a maximum thickness of 50 $\mu$m.

6. The method according to one of claims 3 to 5, **characterized in that** the at least one metallic component is produced by electrochemical deposition.

7. The method according to one of claims 1 to 6, **characterized in that** a plurality of metallic components is created and arranged on a roller as the base.

8. The method according to one of claims 1 to 7, **characterized in that** the film blank is supplied with a thermoplastic carrier layer (4) made of a polymer or copolymer which optionally comprises an adhesive coating (3) on an underside.

9. Use of a film (2) which has microstructures in the form of longitudinal ribs (7) on one surface, on a surface of a body (1) moved in a medium to reduce a flow resistance of the body (1), wherein the film (2) comprises a carrier layer (4) made of a thermoplastic material and a top layer (6) applied directly or indirectly thereto, wherein the longitudinal ribs (7) are formed on or in the top coat (6), which ribs exhibit a spacing that corresponds to a value s in the equation

$$s + = \frac{s\sqrt{\tau_W / \rho}}{\nu}$$

wherein a value s+ in the range of 10 and 20, preferably 12 to 18, is selected and wherein $\tau_W$ corresponds to the mean wall shear stress, $\rho$ to the density of the medium and v to the kinematic viscosity of the medium.

10. Use of a film (2) according to claim 9, **characterized in that** the top layer (6) is made of a cured lacquer.

11. Use of a film (2) according to claim 10, **characterized in that** the top layer has a maximum thickness of 50 $\mu$m, preferably 15 $\mu$m.

12. Use of a film (2) according to one of claims 9 to 11, **characterized in that** the top layer (6) substantially completely covers an adhesion-promoting layer (5) optionally arranged between the carrier layer (4) and top layer (6) or the carrier layer (4).

13. Use of a film (2) according to one of claims 9 to 12, **characterized in that** the carrier layer (4) has a maximum thickness of 5 to 75 $\mu$m, preferably 10 to 25 $\mu$m.

14. Use of a film (2) according to one of claims 9 to 13, **characterized in that** the longitudinal ribs (7) are separated from one another by planar surfaces of the top layer (6).

15. Use of a film (2) according to one of claims 9 to 14, **characterized in that** the film (2) has an average mass of less than 300 gm$^{-2}$, preferably less than 50 gm$^{-2}$.

16. Use of a film (2) according to one of claims 9 to 15, **characterized in that** the longitudinal ribs (7) have a substructure.

## Revendications

1. Procédé, destiné à produire un film (2), comportant des microstructures sous la forme de nervures longitudinales (7) que l'on applique sur un corps (1) qui doit être ou qui est déplacé dans un milieu, de sorte que les nervures longitudinales (7) se situent sur la face extérieure, pour être en contact avec le milieu et pour réduire une résistance à l'écoulement du corps (1) dans le milieu, **caractérisé en ce qu'**on calcule un écart des nervures longitudinales (7) en relation avec une réduction de la résistance à l'écoulement du corps (1) dans le milieu **en ce que**, pour une vitesse d'écoulement prédéfinie et une viscosité cinématique prédéfinie, on calcule de manière ponctuelle ou continue des frottements superficiels sur le corps (1) et à partir de ces derniers, un frottement superficiel moyen, lors d'un déplacement du corps (1) dans le milieu, suite à quoi, pour le frottement superficiel moyen déterminé, on calcule à l'aide de l'équation

$$S+ = \frac{s\sqrt{\tau_W / \rho}}{v}$$

une valeur s qui correspond à un écart des nervures longitudinales (7), une valeur s+ de l'ordre de 10 à 20, de préférence de 12 à 18 étant sélectionnée et $\tau w$ correspondant au frottement superficiel moyen, p à la densité du milieu et v à la viscosité cinématique du milieu, suite à quoi, on créé au moins un composant métallique qui comporte des contours négatifs des nervures longitudinales (7) présentant l'écart calculé, suite à quoi, on prépare une ébauche de film et dans la suite, avec l'au moins un composant, on moule les nervures longitudinales (7) sur ou dans l'ébauche de film, en créant le film (2) comportant des nervures longitudinales (7)

2. Procédé selon la revendication 1, **caractérisé en ce qu'**à l'aide des frottements superficiels déterminés de manière ponctuelle ou continue, on vérifie pour la valeur s de l'écart des nervures longitudinales (7) si la valeur s+ se situe pour au moins 70 %, de préférence pour au moins 80 %, notamment pour au moins 95 % des valeurs des frottements superficiels entre 4 et 30, de préférence entre 7 et 25 et si ce critère n'est pas satisfait, on sélectionne une nouvelle valeur s+ et ainsi un écart entre les nervures longitudinales (7) jusqu'à la conclusion positive de la vérification.

3. Procédé selon la revendication 1 ou 2, **caractérisé en ce qu'**après le calcul de l'écart des nervures longitudinales (7), on créé par lithographie interférentielle des reproductions des nervures longitudinales (7) sur ou dans une matière plastique, suite à quoi, on moule le négatif des reproductions des nervures longitudinales (7) dans un métal ou un alliage, pour créer ainsi au moins un composant métallique pourvu de contours négatifs correspondants, par la suite, on place le composant sur une base, pour préparer ensuite l'ébauche de film comprenant une couche porteuse (4) et une couche protectrice (6) en un vernis durcissable, appliquée indirectement ou directement sur ladite couche porteuse (4), suite à quoi, avec la base comportant le composant métallique, on moule dans le vernis durcissable de l'ébauche de film les nervures longitudinales (7), puis on fait durcir le vernis.

4. Procédé selon la revendication 3, **caractérisé en ce qu'**on fait durcir le vernis pas irradiation à la lumière ultraviolette.

5. Procédé selon la revendication 3 ou 4, **caractérisé en ce qu'**on prépare l'ébauche de film avec une couche protectrice (6) composée du vernis durcissable d'une épaisseur maximale de 50 $\mu$m.

6. Procédé selon l'une quelconque des revendications 3 à 5, **caractérisé en ce qu'**on créé l'au moins un composant métallique par dépôt électrochimique.

7. Procédé selon l'une quelconque des revendications 1 à 6, **caractérisé en ce qu'**on créé plusieurs composants métalliques et on les place en tant que base sur un cylindre.

8. Procédé selon l'une quelconque des revendications 1 à 7, **caractérisé en ce qu'**on prépare l'ébauche de film avec une couche porteuse (4) thermoplastique en un polymère ou copolymère qui comporte en option sur une face inférieure un revêtement adhésif (3).

9. Utilisation d'un film (2), qui sur une surface comporte des microstructures sous la forme de nervures longitudinales (7) sur une surface d'un corps (1) déplacé dans un milieu, pour réduire une résistance à l'écoulement du corps (1), le film (2) comprenant une couche porteuse (4) en une matière thermoplastique et une couche protectrice (6) appliquée indirectement ou directement sur celle-ci, sur ou dans la couche protectrice (6) étant moulées les nervures longitudinales (7) qui présentent un écart qui correspond à une valeur s dans l'équation

$$S+ = \frac{s\sqrt{\tau_W / \rho}}{v}$$

une valeur s+ de l'ordre de 10 à 20, de préférence de 12 à 18 étant sélectionnée et τw correspondant au frottement superficiel moyen, ρ à la densité du milieu et v à la viscosité cinématique du milieu.

10. Utilisation d'un film (2) selon la revendication 9, la couche protectrice (6) étant constituée d'un vernis durci.

11. Utilisation d'un film (2) selon la revendication 10, la couche protectrice présentant une épaisseur maximale de 50 μm, de préférence de 15 μm.

12. Utilisation d'un film (2) selon l'une quelconque des revendications 9 à 11, la couche protectrice (6) recouvrant sensiblement en totalité une couche de promotion d'adhérence (5) placée en option entre la couche porteuse (4) et la couche protectrice (6) ou la couche porteuse (4).

13. Utilisation d'un film (2) selon l'une quelconque des revendications 9 à 12, la couche porteuse (4) présentant une épaisseur maximale de 5 à 75 μm, de préférence de 10 à 25 μm.

14. Utilisation d'un film (2) selon l'une quelconque des revendications 9 à 13, les nervures longitudinales (7) étant séparées les uns des autres par des surface planes de la couche protectrice (6).

15. Utilisation d'un film (2) selon l'une quelconque des revendications 9 à 14, le film (2) présentant une masse moyenne inférieure à 300 gm$^{-2}$, de préférence inférieure à 50 gm$^{-2}$.

16. Utilisation d'un film (2) selon l'une quelconque des revendications 9 à 15, les nervures longitudinales (7) comportant une substructure.

Fig. 1

Fig. 2

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0205289 A1

- DE 19650439 C1